# EUROPEAN PATENT APPLICATION

(11) **EP 4 694 583 A1**
(43) Date of publication of application: **11.02.2026**
(21) Application number: 24844392.1
(22) Date of filing: 03.06.2024
(51) Int. Cl.: H05K 1/02, H05K 1/18, H05K 5/02, H05K 7/14, H04M 1/02, G09F 9/30

(54) **ELECTRONIC DEVICE AND CIRCUIT CONNECTION ASSEMBLY**

(30) Priority: 24.07.2023 CN 202310913929
(71) Applicant: Huawei Technologies Co., Ltd., Shenzhen, Guangdong 518129 (CN)
(72) Inventor: HU, Jian, Shenzhen, Guangdong 518129 (CN); WANG, Junping, Shenzhen, Guangdong 518129 (CN); TANG, Huijun, Shenzhen, Guangdong 518129 (CN); ZHAO, Haojie, Shenzhen, Guangdong 518129 (CN)
(74) Representative: Gill Jennings & Every LLP
(86) International application number: PCT/CN2024/096945
(87) International publication number: WO 2025/020697

(57) **Abstract**

This application provides an electronic device and a circuit connection assembly. The electronic device includes a first fastening part, a rotating part, a second fastening part, and at least one layer of flexible printed circuit board. The second fastening part and the first fastening part are respectively located on two sides of the rotating part in a first direction. Two ends of the flexible printed circuit board in the first direction are respectively connected to the first fastening part and the second fastening part. At least some portions that are on the flexible printed circuit board and that are located between the first fastening part and the second fastening part are connected to the rotating part. The flexible printed circuit board is provided with at least one strip-shaped hole, the strip-shaped hole extends in the first direction, and at least a portion of the strip-shaped hole is located between the first fastening part and the second fastening part. In this application, the flexible printed circuit board is provided with the strip-shaped hole, so that portions that are on the flexible printed circuit board and that are located between the first fastening part and the second fastening part can be separated into a plurality of transmission segments with small widths, to avoid excessive twist of the flexible printed circuit board in a process in which the flexible printed circuit board is bent, thereby prolonging a service life of the flexible printed circuit board.

## Description

The present invention claims priority to Chinese Patent Application No. 202310913929.2, filed with the China National Intellectual Property Administration on July 24, 2023 and entitled "ELECTRONIC DEVICE AND CIRCUIT CONNECTION ASSEMBLY", which is incorporated herein by reference in its entirety.

### TECHNICAL FIELD

This application relates to the field of electronic device technologies, and in particular, to an electronic device and a circuit connection assembly.

### BACKGROUND

In general, for a foldable electronic product, components located on two sides of a bendable region are electrically connected through a flexible printed circuit board (Flexible Printed Circuit, FPC). However, with expansion of a size of the foldable electronic product and improvement of functions of the foldable electronic product, a quantity of needed signals is greatly increasing and accordingly the FPC has an increasingly large width. During folding of the electronic product, there is an increasingly high risk of distorting the wide FPC in a width direction of the FPC. The distortion problem greatly affects a service life of the FPC.

### SUMMARY

An objective of this application is to provide an electronic device and a circuit connection assembly, to resolve a problem in conventional technologies that a service life of an FPC is shortened because the FPC is distorted to a great extent due to an excessively large width of the FPC in a folding process of an electronic device.

This application provides an electronic device, including a first fastening part, a rotating part, a second fastening part, and at least one layer of flexible printed circuit board. The second fastening part and the first fastening part are respectively located on two sides of the rotating part in a first direction. Two ends of the flexible printed circuit board in the first direction are respectively connected to the first fastening part and the second fastening part. At least some portions that are on the flexible printed circuit board and that are located between the first fastening part and the second fastening part are connected to the rotating part. The flexible printed circuit board is provided with at least one strip-shaped hole, the strip-shaped hole extends in the first direction, and at least a portion of the strip-shaped hole is located between the first fastening part and the second fastening part.

In this application, the flexible printed circuit board is provided with the strip-shaped hole, so that portions that are on the flexible printed circuit board and that are located between the first fastening part and the second fastening part can be separated into a plurality of transmission segments with small widths, to avoid significant twist of the flexible printed circuit board in a process in which the flexible printed circuit board is bent, thereby prolonging a service life of the flexible printed circuit board.

In a possible design, a length of the strip-shaped hole in the first direction is greater than or equal to a distance between the first fastening part and the second fastening part.

A portion that is prone to twist on the flexible printed circuit board is located at a position where the flexible printed circuit board is aligned with an inner edge of the first fastening part. The inner edge of the first fastening part is an edge that is of the first fastening part and that faces a side surface of the second fastening part. Similarly, another portion that is prone to twist on the flexible printed circuit board is located at a position where the flexible printed circuit board is aligned with an inner edge of the second fastening part. The inner edge of the second fastening part is an edge that is of the second fastening part and that faces a side surface of the first fastening part. In this embodiment, the length of the strip-shaped hole in the first direction X is greater than or equal to the distance between the first fastening part and the second fastening part, to ensure that the ends of the strip-shaped hole can extend to the inner edge of the first fastening part and the inner edge of the second fastening part, so that two adjacent transmission segments can be separated by the strip-shaped hole at the inner edge of the first fastening part and at the inner edge of the second fastening part. In this way, each transmission segment has a small width at a position where the transmission segment is aligned with the inner edge of the first fastening part, and has a small width at a position where the transmission segment is aligned with the inner edge of the second fastening part, and the transmission segments do not affect each other, thereby effectively reducing an amount of twist and prolonging the service life of the flexible printed circuit board.

In a possible design, one end of the strip-shaped hole in the first direction is aligned with the inner edge of the first fastening part; and/or the other end of the strip-shaped hole in the first direction is aligned with the inner edge of the second fastening part.

When the flexible printed circuit board is prone to twist on one side of the first fastening part, one end of the strip-shaped hole in the first direction X may be aligned with the inner edge of the first fastening part, so that two adjacent transmission segments can be separated by the strip-shaped hole at positions where the two adjacent transmission segments are aligned with the inner edge of the first fastening part. In this way, the transmission segments have small widths at the positions where the transmission segments are aligned with the inner edge of the first fastening part, and the transmission segments do not affect each other, thereby effectively reducing the amount of twist and prolonging the service life of the flexible printed circuit board.

In a possible design, the flexible printed circuit board is separated by the strip-shaped hole into a plurality of transmission segments, the plurality of transmission segments are portions that are on the flexible printed circuit board and that are located between the first fastening part and the second fastening part, at least some of the plurality of transmission segments have different widths in a second direction, and the second direction is perpendicular to the first direction.

Edges that are of each transmission segment and that are connected to the first fastening part and the second fastening part have small widths in the second direction Y, and the width can be less than 15 mm, so that an amount of distortion due to twist can be reduced or even no twist is caused.

In a possible design, a plurality of strip-shaped holes are spaced apart in the second direction. A plurality of transmission segments can be formed through separation by the plurality of strip-shaped holes, so that each transmission segment has a small width while it is ensured that each transmission segment implements a normal function, thereby avoiding significant twist of the flexible printed circuit board.

In a possible design, a width of the strip-shaped hole in the second direction is greater than or equal to 1 mm, and the second direction is perpendicular to the first direction, to ensure that the amount of twist of the flexible printed circuit board is fully absorbed through the strip-shaped hole, thereby ensuring overall stability of the flexible printed circuit board.

In a possible design, at least one of the first fastening part and the second fastening part is provided with a protruding part, the protruding part protrudes between the first fastening part and the second fastening part, and the transmission segment is connected to the protruding part.

In a possible design, there are a plurality of protruding parts on the first fastening part and/or the second fastening part, and at least some of the protruding parts have different protruding lengths in the first direction. The first protruding part is disposed to reduce the distance between the first fastening part and the second fastening part at some positions, thereby reducing a length of the transmission segment.

In a possible design, the rotating part includes a plurality of connection parts, each connecting part is connected to a corresponding transmission segment, distances between at least some of the connection parts and the first fastening part are different, and/or distances between at least some of the connection parts and the second fastening part are different.

No twist is caused at a position of the flexible printed circuit board where the connecting part is connected, and a portion that is on the flexible printed circuit board and that is between the connecting part and the first fastening part and a portion that is on the flexible printed circuit board and that is between the connecting part and the second fastening part are prone to twist. Because the connecting part covers a specific portion of the length of the transmission segment in the first direction X, the length of the transmission segment is reduced. In this way, a transmission segment with a larger width can have a smaller length.

In a possible design, the electronic device includes a first housing, a second housing, and a hinge assembly. The first housing and the second housing are respectively located on two sides of the hinge assembly. The first housing and the second housing are separately in rotary connection to the hinge assembly. A portion of the first housing forms the first fastening part, a portion of the second housing forms the second fastening part, and the hinge assembly is the rotating part. In this way, a quantity of components and parts can be reduced, thereby facilitating miniaturization of the electronic device.

In a possible design, the electronic device includes a first housing, a second housing, and a hinge assembly. The first housing and the second housing are respectively located on two sides of the hinge assembly. The first housing and the second housing are separately in rotary connection to the hinge assembly. One side of the first fastening part is connected to the flexible printed circuit board, and one side that is of the first fastening part and that is away from the flexible printed circuit board is connected to the first housing. One side of the second fastening part is connected to the flexible printed circuit board, and one side that is of the second fastening part and that is away from the flexible printed circuit board is connected to the second housing. The first fastening part and the second fastening part that are disposed as independent mechanical parts, to improve structural reliability in assembling the flexible printed circuit board with the first housing and the second housing and further ensure that the flexible printed circuit board in the electronic device has a stable form.

In a possible design, the first fastening part or the second fastening part is an integrated structure. Therefore, structural strength of the first fastening part and the second fastening part can be improved, and the flexible printed circuit board can be fastened to the first fastening part and the second fastening part, thereby improving reliability of relative connections between the flexible printed circuit board and the first housing and between the flexible printed circuit board and the second housing through the first fastening part and the second fastening part. In addition, a quantity of components and parts can also be reduced, to reduce a quantity of assembly tolerances of the components and parts, thereby ensuring precision of assembling the first fastening part and the second fastening part.

In a possible design, the flexible printed circuit board is separated by the strip-shaped hole into a plurality of transmission segments, a plurality of first fastening parts or second fastening parts are disposed, and each first fastening part or second fastening part is connected to a corresponding transmission segment.

Each first fastening part and each second fastening part may be separately processed and manufactured, so that the first fastening part and the second fastening part with different specifications and sizes can be easily manufactured. Each first fastening part and each second fastening part can ensure relative strength of fastening between the flexible printed circuit board and the first housing, and between the flexible printed circuit board and the second housing, and can also reinforce each transmission segment to ensure stability of each transmission segment.

In a possible design, a first positioning post and a second positioning post are disposed on each of the first housing and the second housing, and the first fastening part and the second fastening part both are provided with a first positioning hole and a second positioning hole. The first positioning hole in the first fastening part or the second fastening part respectively fits with a corresponding first positioning post. The second positioning hole in the first fastening part or the second fastening part respectively fits with a corresponding second positioning post. A gap between the second positioning post and the second positioning hole is greater than a gap between the first positioning post and the first positioning hole.

The fitting gap between the first positioning post and the first positioning hole is small, so that the first fastening part and the second fastening part can be precisely located. There is a large fitting gap between the second positioning post and the second positioning hole, so that the first fastening part and the second fastening part can be coarsely located, and the large fitting gap can provide space for adjusting the first fastening part and the second fastening part. When the electronic device is folded, the first fastening part and the second fastening part can be automatically adjusted to proper positions through the gap between the second positioning post and the second positioning hole. In this way, at least a portion of an amount of twist of the flexible printed circuit board caused when the flexible printed circuit board is bent may be transferred to an amount of movement of the first fastening part and the second fastening part at the gap between the second positioning post and the second positioning hole, to reduce the amount of twist of the flexible printed circuit board, thereby prolonging the service life of the flexible printed circuit board.

In a possible design, the electronic device further includes a locking structure. The locking structure tightly presses a side that is of the first fastening part or the second fastening part and that is away from the first housing or the second housing, and the locking structure is connected to the first housing or the second housing.

After the electronic device is folded repeatedly and the first fastening part is adjusted to a proper position through the gap between the second positioning post and the second positioning hole, the locking structures may be employed to tightly press sides that are of the first fastening part and the second fastening part and that are away from the first housing and the second housing, and then the locking structures may be fastened to the corresponding first housing and the second housing through connecting pieces such as screws, pins, or rivets. In this way, the first fastening part may be fastened to the first housing and the second fastening part may be fastened to the second housing under the effect of traction forces of the connecting pieces.

In a possible design, a plurality of layers of flexible printed circuit boards are disposed in a thickness direction of the electronic device, so that a signal quantity requirement can be satisfied through the plurality of flexible printed circuit boards while a width of each flexible printed circuit board in the second direction Y can be reduced, thereby avoiding twist of the flexible printed circuit board when the flexible printed circuit board is bent.

In a possible design, the flexible printed circuit board is an integrated structure, that is, the flexible printed circuit board is an entire circuit board, and the strip-shaped hole may be directly processed and formed on the flexible printed circuit board, thereby reducing a quantity of components and parts and reducing a fitting error.

This application further provides a circuit connection assembly, including a flexible printed circuit board, a first fastening part, and a second fastening part. One end of the flexible printed circuit board in a first direction is connected to at least one first fastening part, and the other end of the flexible printed circuit board in the first direction is connected to at least one second fastening part. The flexible printed circuit board is provided with at least one strip-shaped hole, the strip-shaped hole extends in the first direction, and at least a portion of the strip-shaped hole is located between the first fastening part and the second fastening part.

This application further provides a circuit connection assembly, including a flexible printed circuit board. Two ends of the flexible printed circuit board in a first direction are separately configured to be connected to an electronic device, the flexible printed circuit board is provided with at least one strip-shaped hole, and the strip-shaped hole extends in the first direction.

It should be understood that the foregoing general descriptions and the following detailed descriptions are merely used as examples, and should not limit this application.

### BRIEF DESCRIPTION OF DRAWINGS

To describe technical solutions in embodiments of this application more clearly, the following briefly describes the accompanying drawings that need to be used for embodiments. It is clear that the accompanying drawings in the following descriptions show merely some embodiments of this application, and a person of ordinary skill in the art may derive other drawings from these accompanying drawings without creative efforts.
FIG. 1 is a diagram of a distorted excessively wide FPC;
FIG. 2 is another diagram of a distorted excessively wide FPC;
FIG. 3 is still another diagram of a distorted excessively wide FPC;
FIG. 4 is a diagram of an electronic device in a usage state according to an embodiment of this application;
FIG. 5 is a diagram of an electronic device in another usage state according to an embodiment of this application;
FIG. 6 is a partial view of an electronic device in a flattened state according to an embodiment of this application;
FIG. 7 is a diagram of a wide flexible printed circuit board 1 in a desired twist-free state during application;
FIG. 8 is a diagram of a wide flexible printed circuit board 1 after twist is caused during application;
FIG. 9 is a simulation diagram of a flexing life of a conventional wide flexible printed circuit board;
FIG. 10 is a diagram of a structure of a flexible printed circuit board according to an embodiment of this application;
FIG. 11 is a state diagram of a flexible printed circuit board during application according to an embodiment of this application;
FIG. 12 is another state diagram of a flexible printed circuit board during application according to an embodiment of this application;
FIG. 13 is a simulation diagram of a flexing life of a flexible printed circuit board according to this application;
FIG. 14 is still another state diagram of a flexible printed circuit board during application according to an embodiment of this application;
FIG. 15 is a partial view of an electronic device in a closed state according to an embodiment of this application;
FIG. 16 is a partial view of a process in which an electronic device is opened from a closed state to a flattened state according to an embodiment of this application;
FIG. 17 is a partial view of an electronic device in a flattened state according to another embodiment of this application;
FIG. 18 is yet another state diagram of a flexible printed circuit board during application according to an embodiment of this application;
FIG. 19 is still yet another state diagram of a flexible printed circuit board during application according to an embodiment of this application;
FIG. 20 is a further state diagram of a flexible printed circuit board during application according to an embodiment of this application;
FIG. 21 is a still further state diagram of a flexible printed circuit board during application according to an embodiment of this application;
FIG. 22 is a yet further state diagram of a flexible printed circuit board during application according to an embodiment of this application;
FIG. 23 is a still yet further state diagram of a flexible printed circuit board during application according to an embodiment of this application;
FIG. 24 is a diagram of an electronic device in a flattened state before being folded according to an embodiment of this application;
FIG. 25 is a diagram of an electronic device in a flattened state after being repeatedly folded according to an embodiment of this application;
FIG. 26 is even yet another state diagram of a flexible printed circuit board during application according to an embodiment of this application;
FIG. 27 is a still even yet another state diagram of a flexible printed circuit board during application according to an embodiment of this application; and
FIG. 28 is an exploded view of a plurality of layers of flexible printed circuit boards in a thickness direction of an electronic device.

### Reference numerals:

1: flexible printed circuit board;
11: strip-shaped hole;
12: edge region;
13: transmission segment;
2: first fastening part;
21: inner edge;
3: second fastening part;
31: inner edge;
4: rotating part;
41: connecting part;
5: protruding part;
6: locking structure;
100: first housing;
200: second housing;
300: hinge assembly;
400: first positioning post;
500: second positioning post;
600: first positioning hole;
700: second positioning hole;
X: first direction;
Y: second direction;
Z: thickness direction.

The accompanying drawings herein are incorporated into this specification and form a part of this specification, show embodiments in accordance with this application, and are used together with this specification to explain the principles of this application.

### DESCRIPTION OF EMBODIMENTS

To better understand technical solutions of this application, the following describes embodiments of this application in detail with reference to the accompanying drawings. It should be understood that specific embodiments described herein are merely used to explain this application but are not intended to limit this application.

In descriptions of this application, unless otherwise specified and limited, the terms "first" and "second" are merely intended for a purpose of description, and cannot be understood as an indication or implication of relative importance. Unless otherwise specified or stated, the term "a plurality of" means two or more than two. The terms "connection", "fastening", and the like all should be understood in a broad sense. For example, "connection" may be a fastened connection, or may be a detachable connection, an integrated connection, or an electrical connection; or may be a direct connection, or may be an indirect connection through an intermediate medium. A person of ordinary skill in the art may understand specific meanings of the foregoing terms in this application based on a specific case.

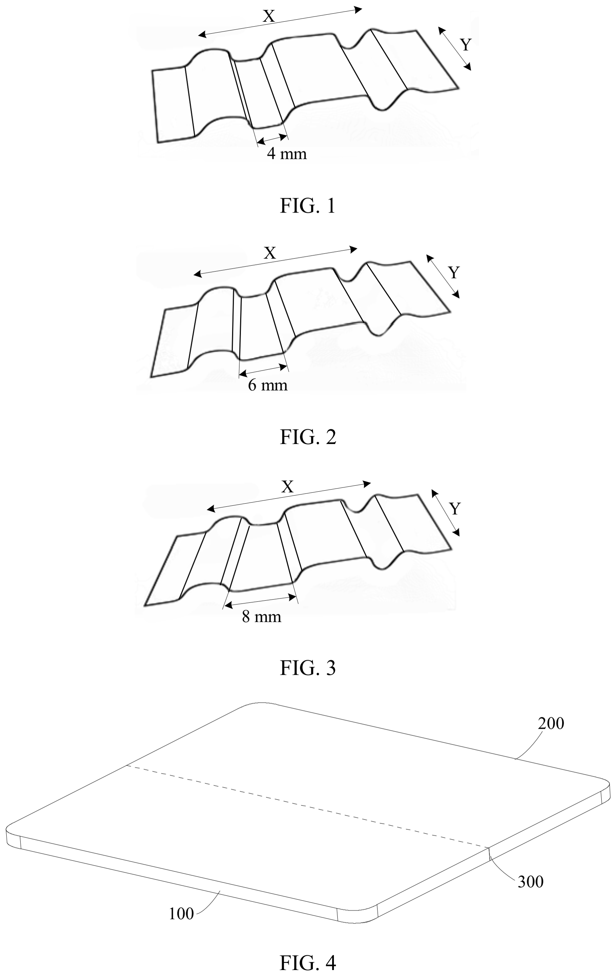

In general, for a foldable electronic product, components located on two sides of a bendable region are electrically connected through a flexible printed circuit board (Flexible Printed Circuit, FPC). The FPC can pass through the bendable region, and can be folded or flattened, due to its own flexibility, along with the electronic product. However, with expansion of a size of the foldable electronic product and improvement of functions of the foldable electronic product, a quantity of signals on the FPC is sharply increasing and accordingly the FPC needs to have an increasingly large width. However, due to existence of an assembly tolerance of the FPC, during folding of the electronic device, an excessively wide FPC may have a problem of distortion in a width direction of the FPC, greatly affecting a flexing life of the FPC. FIG. 1 to FIG. 3 are diagrams of a distorted excessively wide FPC. For ease of description, a length direction of the FPC is defined as a first direction X, and a width direction of the FPC is defined as a second direction Y. The first direction X is perpendicular to the second direction Y. The FPC is distorted in the first direction X. As a result, a portion of one end of the FPC in the second direction Y is compressed, and a portion of the other end is stretched. FIG. 1 shows a state of the FPC twisted by 1°. One end of a twisted region of the FPC has a length of 4 mm after being stretched, and the corresponding other end has a length less than 4 mm. FIG. 2 shows a state of the FPC twisted by 3°. One end of a twisted region of the FPC has a length of 6 mm after being stretched, and the corresponding other end has a length less than 6 mm. FIG. 3 shows a state of the FPC twisted by 10°. One end of a twisted region of the FPC has a length of 8 mm after being stretched, and the corresponding other end has a length less than 8 mm. The foregoing FPC distortion problem greatly affects the flexing life of the FPC.

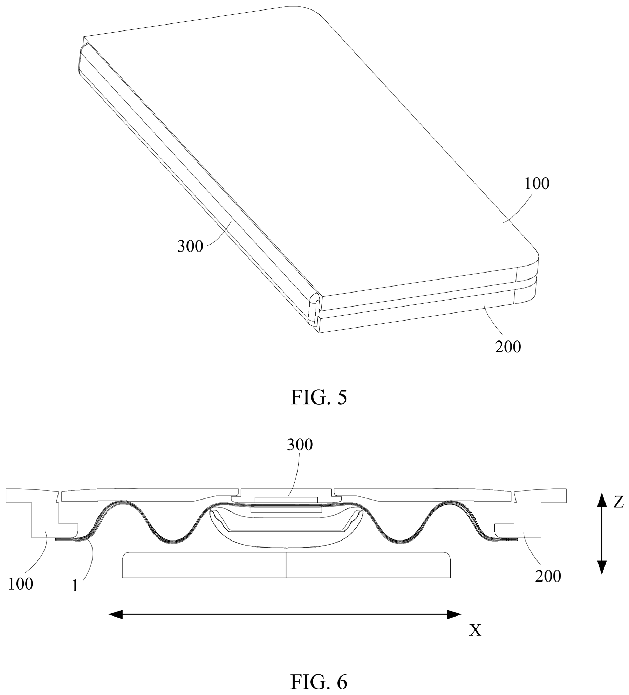

Therefore, an embodiment of this application provides an electronic device. FIG. 4 is a diagram of an electronic device in a usage state according to an embodiment of this application. FIG. 5 is a diagram of an electronic device in another usage state according to an embodiment of this application. Refer to FIG. 4 and FIG. 5. FIG. 4 and FIG. 5 merely show examples in which the electronic device is a foldable mobile phone. The state shown in FIG. 4 is a state in which the foldable mobile phone is flattened, and the state shown in FIG. 5 is a state after the foldable mobile phone is folded. FIG. 6 is a partial view of an electronic device in a flattened state according to an embodiment of this application. Refer to FIG. 6. FIG. 6 shows an example of connection statuses of some parts at a position of a hinge assembly 300 inside a foldable mobile phone. The electronic device includes a first housing 100, a second housing 200, a flexible printed circuit board 1, and the hinge assembly 300. A screen module may be carried above the first housing 100, the second housing 200, and the hinge assembly 300. The flexible printed circuit board 1 may pass through the hinge assembly 300, and two ends of the flexible printed circuit board 1 may be respectively connected to the first housing 100 and the second housing 200.

Certainly, the electronic device may alternatively be a foldable device that uses a flexible printed circuit board to connect components on two sides of a bendable region, such as a foldable computer, a foldable display, a wearable device, or an in-vehicle device. A specific type of the electronic device is not limited in this embodiment.

Specifically, as shown in FIG. 6, the electronic device provided in this embodiment of this application includes a first fastening part 2, a rotating part 4, a second fastening part 3, and at least one layer of flexible printed circuit board 1. The second fastening part 3 and the first fastening part 2 are respectively located on two sides of the rotating part 4 in a first direction X, and the first fastening part 2 and the second fastening part 3 may rotate relative to the rotating part 4.

For example, as shown in FIG. 6, when the electronic device is a foldable device such as a foldable mobile phone or a foldable computer, the rotating part 4 may be the hinge assembly 300, and the electronic device can rotate at the hinge assembly 300, to implement switching between the folded state and the flattened state. For example, when the electronic device is a foldable flexible display, for example, a flexible display including an organic light-emitting diode (organic light-emitting diode, OLED), the rotating part 4 may be a portion of regions of the flexible display, so that the flexible display can be bent.

In addition, for example, the first fastening part 2 and the second fastening part 3 may be a housing, a middle frame, and the like of the electronic device, and functional components may be disposed on the first fastening part 2 and the second fastening part 3. As described previously, for the electronic device which is a foldable mobile phone shown in FIG. 5, the rotating part 4 may be the hinge assembly 300, and the first fastening part 2 and the second fastening part 3 can be separately connected to the hinge assembly 300, so that the first fastening part 2 and the second fastening part 3 can rotate relative to the hinge assembly 300. For example, the first fastening part 2 and the second fastening part 3 may alternatively be independent mechanical parts, for example, metal sheets. The first fastening part 2 and the second fastening part 3 may be mounted on the housing and the middle frame of the electronic device, and can enhance connection and structural strength of the flexible printed circuit board 1.

Two ends of the flexible printed circuit board 1 in the first direction X are respectively connected to the first fastening part 2 and the second fastening part 3, and at least some portions that are on the flexible printed circuit board 1 and that are located between the first fastening part 2 and the second fastening part 3 are connected to the rotating part 4. Specifically, the flexible printed circuit board 1 may be separately bonded to the first fastening part 2, the second fastening part 3, and the rotating part 4 by using glue. For example, when the first fastening part 2 and the second fastening part 3 are the housing and the middle frame of the electronic device, or are some structures of the housing and the middle frame of the electronic device, the flexible printed circuit board 1 may be bonded to the housing or the middle frame of the electronic device by using glue. For example, when the first fastening part 2 and the second fastening part 3 are independent mechanical parts such as metal sheets, two ends of the flexible printed circuit board 1 may be respectively bonded to the corresponding first fastening part 2 and the corresponding second fastening part 3, so that the flexible printed circuit board 1, the first fastening part 2, and the second fastening part 3 are an integral circuit connection assembly. Then, the first fastening part 2 and the second fastening part 3 that are separately connected to the flexible printed circuit board 1 may be assembled to the housing or the middle frame of the electronic device. In this way, it can be ensured, through constraint from the first fastening part 2 and the second fastening part 3, that an overall form of the flexible printed circuit board 1 is stable after the flexible printed circuit board 1 is mounted onto the electronic device.

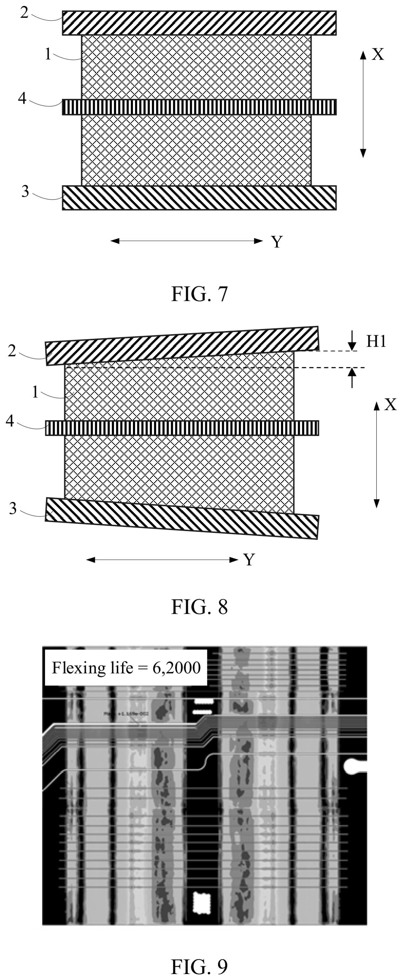

FIG. 7 is a diagram of a wide flexible printed circuit board 1 in a desired twist-free state during application. As shown in FIG. 7, in the desired state in which there is no assembly tolerance between the flexible printed circuit board 1 and the first fastening part 2 or the second fastening part 3, the flexible printed circuit board 1 is not twisted during operation. However, in an actual assembly process, there is a specific assembly tolerance between the flexible printed circuit board 1 and the first fastening part 2 or the second fastening part 3. In addition, when the electronic device is repeatedly folded for use, there may be slight drastic movement at a connection position between the flexible printed circuit board 1 and the first fastening part 2 or the second fastening part 3, causing an amount of twist of the flexible printed circuit board 1. For example, FIG. 8 is a diagram of a wide flexible printed circuit board 1 after twist is caused during application. As shown in FIG. 8, when the first fastening part 2 and the second fastening part 3 drive two ends of the flexible printed circuit board 1 to fold relative to the rotating part 4, if the width of the flexible printed circuit board 1 in the second direction Y is excessively large, for example, the width of the flexible printed circuit board 1 in the second direction Y is 20 mm to 100 mm or even larger, a portion that is on the flexible printed circuit board 1 and that is located between the first fastening part 2 and the second fastening part 3 is prone to significant twist. Such twist causes a portion of the flexible printed circuit board 1 to be stretched by 3 mm to 8 mm in the first direction X. As shown in FIG. 8, an edge on one side of the flexible printed circuit board 1 in the width direction of the flexible printed circuit board 1 is stretched by a distance H1, and H1 is 3 mm to 8 mm. As a result, fatigue of the flexible printed circuit board 1 is accelerated at a twisted position, and a service life of the flexible printed circuit board 1 is shortened. FIG. 9 is a simulation diagram of a flexing life of a conventional wide flexible printed circuit board. As shown in FIG. 9, the flexing life of the flexible printed circuit board is 62,000 times.

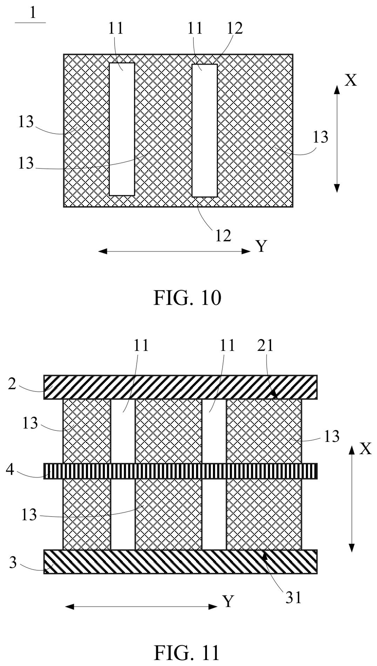

To reduce the fatigue and prolong the service life of the flexible printed circuit board 1, in this embodiment, as shown in FIG. 10 which is a diagram of a structure of a flexible printed circuit board 1 according to an embodiment of this application, the flexible printed circuit board 1 is provided with at least one strip-shaped hole 11, the strip-shaped hole 11 extends in the first direction X, and at least a portion of the strip-shaped hole 11 is located between the first fastening part 2 and the second fastening part 3. The flexible printed circuit board 1 is an integrated structure, that is, the flexible printed circuit board 1 is an entire circuit board, and the strip-shaped hole 11 does not pass through edges of the flexible printed circuit board 1 in the first direction X. In other words, regions near the edges on two sides of the flexible printed circuit board 1 in the first direction X still have specific widths. This portion of edge regions 12 on the two sides of the flexible printed circuit board 1 can be connected to the first fastening part 2 and the second fastening part 3, and a transmission line can be arranged in this portion of edge regions 12. To be specific, there is a transmission line layer inside the flexible printed circuit board 1, some transmission lines in the transmission line layer may be located in the edge region 12, and the transmission lines located in the edge region 12 can be conveniently connected to other components or lines outside the flexible printed circuit board 1, for example, connected to external connectors.

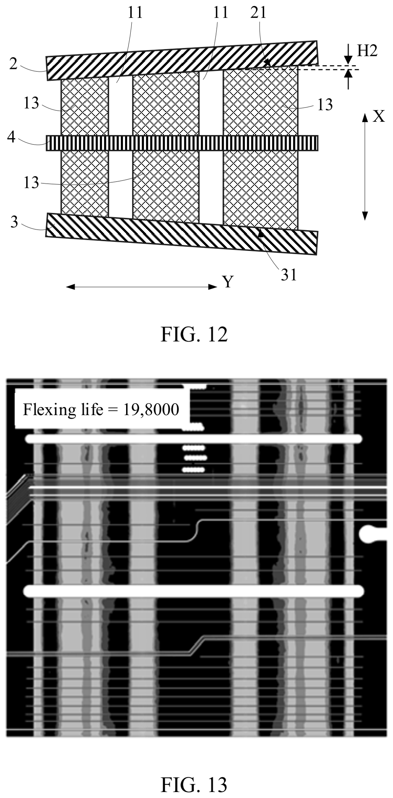

In this embodiment, the strip-shaped hole 11 is arranged between the first fastening part 2 and the second fastening part 3. The strip-shaped hole 11 can separate the portion that is on the flexible printed circuit board 1 and that is located between the first fastening part 2 and the second fastening part 3 into a plurality of transmission segments 13. Therefore, each transmission segment 13 may have a small width. For example, the width of each transmission segment 13 in the second direction Y may be controlled to be within 15 mm. FIG. 11 is a state diagram of a flexible printed circuit board 1 during application according to an embodiment of this application. As shown in FIG. 11, during folding of the electronic device, a transmission segment 13 with a small width is not prone to twist. FIG. 12 is another state diagram of a flexible printed circuit board 1 during application according to an embodiment of this application. As shown in FIG. 12, even if the transmission segment 13 is twisted, because the width of the transmission segment 13 is small, an amount H2 of twist of the transmission segment 13 in the first direction X may be controlled to be within 1.5 mm. In addition, because two adjacent transmission segments 13 are separated by the strip-shaped hole 11, states of the two adjacent transmission segments 13 do not affect each other, and impact of a minor amount of twist on a fatigue life of the flexible printed circuit board 1 may be ignored. FIG. 13 is a simulation diagram of a flexing life of a flexible printed circuit board according to this application. As shown in FIG. 13, the life of the flexible printed circuit board having the strip-shaped hole 11 during application is 198,000 times. In comparison with the flexible printed circuit board shown in FIG. 7, the flexing life of the flexible printed circuit board provided in this embodiment of this application is improved by more than three times.

Therefore, in this embodiment, the flexible printed circuit board 1 is provided with the strip-shaped hole 11, so that the portion that is on the flexible printed circuit board 1 and that is located between the first fastening part 2 and the second fastening part 3 may be separated into the plurality of transmission segments 13 with small widths, to avoid significant twist of the flexible printed circuit board 1 during folding of the electronic device, thereby prolonging the service life of the flexible printed circuit board 1.

A width of the strip-shaped hole 11 in the second direction Y may be greater than or equal to 1 mm, to ensure that the amount of twist of the flexible printed circuit board 1 is fully absorbed through the strip-shaped hole 11, thereby ensuring overall stability of the flexible printed circuit board 1. Certainly, in some other application scenarios, the width of the strip-shaped hole 11 may alternatively be less than 1 mm. This is not limited in this embodiment.

In a specific implementation, a length of the strip-shaped hole 11 in the first direction X is greater than or equal to a distance between the first fastening part 2 and the second fastening part 3. As shown in FIG. 11, a portion that is prone to twist on the flexible printed circuit board 1 is located at a position where the flexible printed circuit board 1 is aligned with an inner edge 21 of the first fastening part 2, and the inner edge 21 of the first fastening part 2 is an edge that is of the first fastening part 2 and that faces a side surface of the second fastening part 3. Similarly, another portion that is prone to twist on the flexible printed circuit board 1 is located at a position where the flexible printed circuit board 1 is aligned with an inner edge 31 of the second fastening part 3, and the inner edge 31 of the second fastening part 3 is an edge that is of the second fastening part 3 and that faces a side surface of the first fastening part 2. In this embodiment, the length of the strip-shaped hole 11 in the first direction X is greater than or equal to the distance between the first fastening part 2 and the second fastening part 3, to ensure that the ends of the strip-shaped hole 11 can extend to the inner edge 21 of the first fastening part 2 and the inner edge 31 of the second fastening part 3, so that two adjacent transmission segments 13 can be separated by the strip-shaped hole 11 at the inner edge 21 of the first fastening part 2 and at the inner edge 31 of the second fastening part 3. In this way, each transmission segment 13 has a small width at a position where the transmission segment 13 is aligned with the inner edge 21 of the first fastening part 2, and has a small width at a position where the transmission segment 13 is aligned with the inner edge 31 of the second fastening part 3, and the transmission segments 13 do not affect each other, thereby effectively reducing an amount of twist and prolonging the service life of the flexible printed circuit board 1.

In a specific implementation, one end of the strip-shaped hole 11 in the first direction X is aligned with the inner edge 21 of the first fastening part 2; and/or the other end of the strip-shaped hole 11 in the first direction X is aligned with the inner edge 31 of the second fastening part 3.

For example, when the flexible printed circuit board 1 is prone to twist on one side of the first fastening part 2, one end of the strip-shaped hole 11 in the first direction X may be aligned with the inner edge 21 of the first fastening part 2, so that two adjacent transmission segments 13 can be separated by the strip-shaped hole 11 at positions where the two adjacent transmission segments 13 are aligned with the inner edge 21 of the first fastening part 2. In this way, the transmission segments 13 have small widths at the positions where the transmission segments 13 are aligned with the inner edge 21 of the first fastening part 2, and the transmission segments 13 do not affect each other, thereby effectively reducing the amount of twist and prolonging the service life of the flexible printed circuit board 1. The other end of the strip-shaped hole 11 in the first direction X may not extend to the inner edge 31 of the second fastening part 3, or certainly may extend to the inner edge 31 of the second fastening part 3.

For example, when the flexible printed circuit board 1 is prone to twist on one side of the second fastening part 3, one end that is of the strip-shaped hole 11 and that is far away from the first fastening part 2 in the first direction X may be aligned with the inner edge 31 of the second fastening part 3. An effect thereof is the same as described previously, and details are not described herein.

For example, the two ends of the strip-shaped hole 11 may respectively extend to positions where the strip-shaped hole 11 is aligned with the inner edge 21 of the first fastening part 2 and the inner edge 31 of the second fastening part 3, to reduce amounts of twist of the flexible printed circuit board 1 at positions where the flexible printed circuit board 1 is connected to the first fastening part 2 and the second fastening part 3, thereby prolonging the service life of the flexible printed circuit board 1.

In a specific implementation, as shown in FIG. 10, the flexible printed circuit board 1 is separated by the strip-shaped hole 11 into a plurality of transmission segments 13. As shown in FIG. 11, the plurality of transmission segments 13 are portions that are on the flexible printed circuit board 1 and that are located between the first fastening part 2 and the second fastening part 3, at least some of the plurality of transmission segments 13 have different widths in the second direction Y, and the second direction Y is perpendicular to the first direction X. As described previously, the portion that is on the flexible printed circuit board 1 and that is prone to distortion due to twist is mainly located in a region between the first fastening part 2 and the second fastening part 3, especially at positions where the flexible printed circuit board 1 is aligned with the inner edge 21 of the first fastening part 2 and the inner edge 31 of the second fastening part 3. In this embodiment, for ease of description, portions that are on the flexible printed circuit board 1, located between the first fastening part 2 and the second fastening, and separated by the strip-shaped hole 11 may be defined as the transmission segments 13. Edges of each transmission segment 13 that are connected to the first fastening part 2 and the second fastening part 3 have small widths in the second direction Y. The width can be less than 15 mm, so that an amount of distortion due to twist can be reduced, or even there is no twist at all. In addition, widths of some of the transmission segments 13 may be different, so that different signal transmission functions can be implemented separately. Certainly, in some other embodiments, widths of some of the transmission segments 13 may be the same. This is not limited in this embodiment.

In a specific implementation, a plurality of strip-shaped holes 11 may be spaced apart in the second direction Y. Optionally, two strip-shaped holes 11 may be arranged at an interval, and the flexible printed circuit board 1 may be separated by the two strip-shaped holes 11 into three transmission segments. Optionally, when an overall size of the flexible printed circuit board 1 is large, three or more strip-shaped holes 11 may be arranged. The three or more strip-shaped holes 11 can separate more transmission segments 13, so that each transmission segment 13 has a small width while it is ensured that each transmission segment 13 implements a normal function, thereby avoiding significant twist of the flexible printed circuit board 1.

Certainly, in some other embodiments, when the overall size of the flexible printed circuit board 1 is small, only one strip-shaped hole 11 may be arranged to separate two transmission segments 13, so that the two transmission segments 13 can implement normal functions and have small widths, thereby avoiding significant twist.

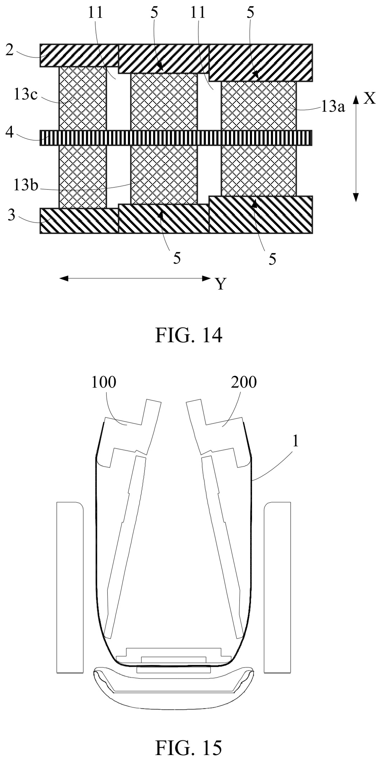

In a specific implementation, a length of the transmission segment 13 in the first direction X is inversely proportional to a width of the transmission segment 13 in the second direction Y. FIG. 14 is still another state diagram of a flexible printed circuit board 1 during application according to an embodiment of this application. As shown in FIG. 14, a required length of the transmission segment 13 decreases as the width of the transmission segment 13 increases. The length of the transmission segment 13 may be designed based on the width of the transmission segment 13. When the width of the transmission segment 13 increases, the transmission segment 13 is more prone to twist. Therefore, the length of the transmission segment 13 may be reduced to improve structural stability of the transmission segment 13 and reduce twist.

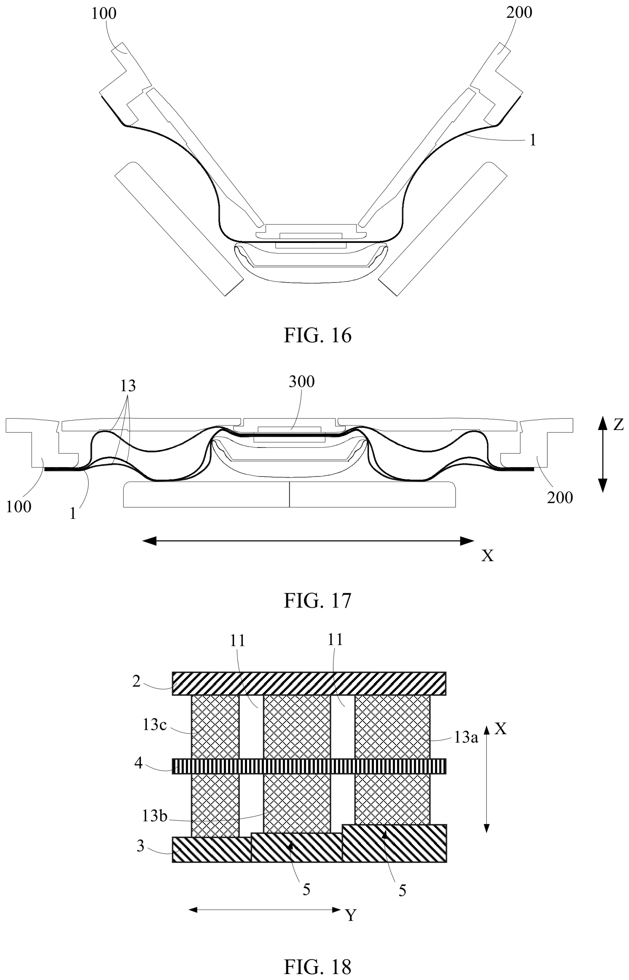

In addition, FIG. 15 is a partial view of an electronic device in a closed state according to an embodiment of this application. As shown in FIG. 15, when the electronic device is in the closed state, the flexible printed circuit board 1 may be stretched as a whole, and basically the flexible printed circuit board 1 is not wrinkled. FIG. 16 is a partial view of a process in which an electronic device is opened from a closed state to a flattened state according to an embodiment of this application. As shown in FIG. 16, in the process in which the electronic device is opened gradually to the flattened state, the flexible printed circuit board 1 is squeezed gradually, causing each transmission segment 13 to be wrinkled on the flexible printed circuit board 1. FIG. 17 is a partial view of an electronic device in a flattened state according to another embodiment of this application. FIG. 17 may show a flattened state of the flexible printed circuit board 1 shown in FIG. 11 in the electronic device. The transmission segments 13 shown in FIG. 11 have a same length each in the first direction X, but have different widths in the second direction Y. As a result, the transmission segments 13 are bent to different extent when the electronic device is in the flattened state, resulting in inconsistent fluctuation of the transmission segments 13 in the thickness direction of the electronic device (as shown in FIG. 17) and affecting consistency.

Therefore, in this embodiment, a transmission segment 13 with a larger width has a smaller length, and a transmission segment 13 with a smaller width has a greater length, so that a bent state of each transmission segment 13 after a force is applied can be adjusted, thereby implementing consistency between the bent states of the transmission segments 13 (as shown in FIG. 6).

In a specific implementation, as shown in FIG. 14, at least one of the first fastening part 2 and the second fastening part 3 is provided with a protruding part 5. The protruding part 5 protrudes between the first fastening part 2 and the second fastening part 3, and the transmission segment 13 is connected to the protruding part 5. The protruding part 5 is disposed to reduce the distance between the first fastening part 2 and the second fastening part 3 at some positions, thereby reducing the length of the transmission segment 13.

For example, refer to FIG. 14. FIG. 14 shows an example in which there are three transmission segments 13: a transmission segment 13a, a transmission segment 13b, and a transmission segment 13c. Widths of the transmission segments 13a, 13b, and 13c decrease successively, but lengths of the transmission segment 13a, the transmission segment 13b, and the transmission segment 13c increase successively. Specifically, the protruding parts 5 are disposed on the first fastening part 2 and the second fastening part 3 at two ends of the transmission segment 13a and the transmission segment 13b, but no protruding part 5 is disposed on the first fastening part 2 and the second fastening part 3 at two ends of the transmission segment 13c. Therefore, the lengths of the transmission segment 13a and the transmission segment 13b connected to the protruding parts 5 can be less than the length of the transmission segment 13c that is not connected to any protruding part 5. In addition, a protruding length of the protruding part 5 connected to the transmission segment 13a in the first direction X is greater than a protruding length of the protruding part 5 connected to the transmission segment 13b in the first direction X. In this way, the length of the transmission segment 13a can be less than the length of the transmission segment 13b.

For example, one of the first fastening part 2 and the second fastening part 3 may be provided with the protruding part 5, and the other is not provided with the protruding part 5. FIG. 18 is yet another state diagram of a flexible printed circuit board 1 during application according to an embodiment of this application. As shown in FIG. 18, no protruding part 5 is disposed on the first fastening part 2, and the protruding parts 5 are separately disposed on the second fastening part 3 at positions where the transmission segment 13a and the transmission segment 13b are connected, so that lengths of the transmission segment 13a and the transmission segment 13b can be both less than the length of the transmission segment 13c. In addition, a protruding length of the protruding part 5 connected to the transmission segment 13a is greater than a protruding length of the protruding part 5 connected to the transmission segment 13b, so that the length of the transmission segment 13a with a larger width is less than the length of the transmission segment 13b with a smaller width.

In addition, as shown in FIG. 14, when there are a plurality of protruding parts 5 on the first fastening part 2 and/or the second fastening part 3, between the protruding parts 5 may form a step structure, that is, at least some of the protruding parts 5 protruding between the first fastening part 2 and the second fastening part 3 have different protruding lengths, so that at least some of the transmission segment 13 can have different lengths, to match corresponding widths.

Certainly, in some other embodiments, when there are two transmission segments 13 and widths of the two transmission segments 13 are different, one protruding part 5 may be disposed on the first fastening part 2 that is connected to a transmission segment 13 with a larger width and/or the second fastening part 3 that is connected to the transmission segment 13 with the larger width, to reduce a length of the transmission segment 13 with the larger width.

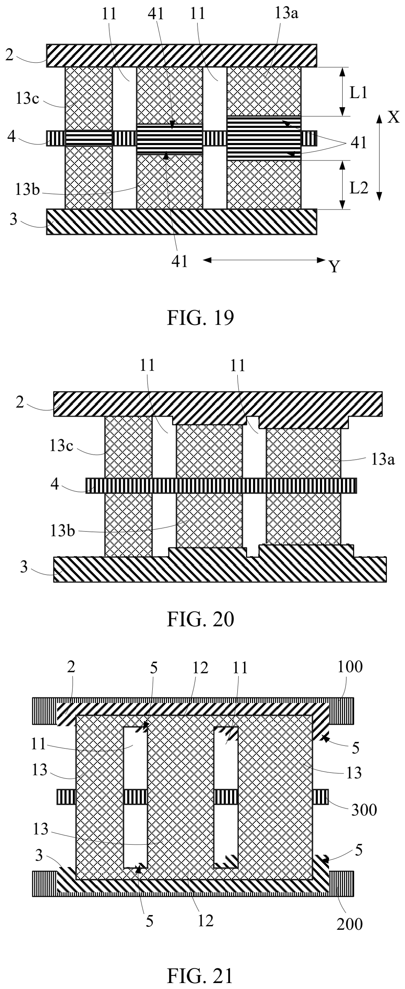

In a specific implementation, FIG. 19 is still yet another state diagram of a flexible printed circuit board 1 during application according to an embodiment of this application. As shown in FIG. 19, the rotating part 4 includes a plurality of connection parts 41, each connecting part 41 is connected to a corresponding transmission segment 13, and distances between at least some of the connecting part 41 and the first fastening part 2 are different, and/or distances between at least some of the connecting part 41 and the second fastening part 3 are different. When the rotating part 4 is a hinge assembly on a foldable mobile phone, the connecting part 41 may be a door plate in the hinge assembly. Certainly, the connecting part 41 may alternatively be a reinforcement structure, for example, a reinforcement metal plate, and the reinforcement metal plate may be fastened onto the door plate of the hinge assembly. No twist is caused at a position of the flexible printed circuit board 1 where the connecting part 41 is connected, and a portion that is on the flexible printed circuit board 1 and that is between the connecting part 41 and the first fastening part 2 and a portion that is on the flexible printed circuit board 1 and that is between the connecting part 41 and the second fastening part 3 are prone to twist. Because the connecting part 41 covers a specific portion of the length of the transmission segment 13 in the first direction X, the length of the transmission segment 13 is reduced. In this way, a transmission segment 13 with a larger width can have a smaller length.

In a specific implementation, as shown in FIG. 19, there may be a plurality of connection parts 41, and at least some of the connection parts 41 have different lengths in the first direction X. In the first direction X, the transmission segment 13 has a first length L1 between the connecting part 41 and the first fastening part 2, the transmission segment 13 has a second length L2 between the connecting part 41 and the second fastening part 3, and a sum of the first length L1 and the second length L2 is inversely proportional to the width of the transmission segment 13 in the second direction Y.

Refer to FIG. 19. A length of the connecting part 41 connected to the transmission segment 13a in the first direction X is greater than a length of the connecting part 41 connected to the transmission segment 13b in the first direction X, so that a sum of the first length L1 and the second length L2 of the transmission segment 13a with a larger width is less than a sum of the first length L1 and the second length L2 of the transmission segment 13b with a smaller width. In addition, the rotating part 4 may not be disposed with the connecting part 41 at a position where the transmission segment 13c with a smallest width is connected, so that a sum of the first length L1 and the second length L2 of the transmission segment 13c with the smallest width may be the largest comparatively.

In a specific implementation as described previously, as shown in FIG. 6, the electronic device may include the first housing 100, the second housing 200, and the hinge assembly 300. The hinge assembly 300 is the rotating part 4, the first housing 100 and the second housing 200 are respectively located on two sides of the hinge assembly 300, and the first housing 100 and the second housing 200 are separately in rotary connection to the hinge assembly 300. When the electronic device is a foldable mobile phone or a foldable computer, the first housing 100 and the second housing 200 may be specifically a middle frame, a rear housing, or the like. The first fastening part 2 and the second fastening part 3 may be respectively the first housing 100 and the second housing 200. When the flexible printed circuit board 1 is connected, some portions of the first housing 100 and the second housing 200 may be configured to be connected to the flexible printed circuit board 1. Alternatively, FIG. 20 is a further state diagram of a flexible printed circuit board 1 during application according to an embodiment of this application. As shown in FIG. 20, the first fastening part 2 and the second fastening part 3 may be respectively some structures of the first housing 100 and the second housing 200. For example, a portion of the first housing 100 forms the first fastening part 2, and a portion of the second housing 200 forms the second fastening part 3. The first fastening part 2 and the second fastening part 3 may be partial surfaces of the first housing 100 and the second housing 200 respectively, and the flexible printed circuit board 1 may be bonded to the corresponding surfaces by using glue.

In a specific implementation, FIG. 21 is a still further state diagram of a flexible printed circuit board 1 during application according to an embodiment of this application. As shown in FIG. 21, the electronic device includes the first housing 100, the second housing 200, and the hinge assembly 300. The first housing 100 and the second housing 200 are respectively located on two sides of the hinge assembly 300, and the first housing 100 and the second housing 200 are separately in rotary connection to the hinge assembly 300. One side of the first fastening part 2 is connected to the flexible printed circuit board 1, and one side that is of the first fastening part 2 and that is away from the flexible printed circuit board 1 is connected to the first housing 100. One side of the second fastening part 3 is connected to the flexible printed circuit board 1, and one side that is of the second fastening part 3 and that is away from the flexible printed circuit board 1 is connected to the second housing 200. In this embodiment, the first fastening part 2 and the second fastening part 3 may be mechanical parts separately manufactured, such as metal sheets. The edge region 12 of the flexible printed circuit board 1 may be fastened and bonded to the first fastening part 2 and the second fastening part 3 by using glue, so that the flexible printed circuit board 1, the first fastening part 2, and the second fastening part 3 form an integrated structure. Then, the first fastening part 2 and the second fastening part 3 may be fastened to the corresponding first housing 100 and the second housing 200 in a manner of glue, soldering, or the like. The first fastening part 2 and the second fastening part 3 are disposed to improve structural reliability in assembling the flexible printed circuit board 1, the first housing 100, and the second housing 200.

In a specific implementation, as shown in FIG. 21, the first fastening part 2 or the second fastening part 3 is an integrated structure, that is, the first fastening part 2 may be directly formed in one process, so that one end of the flexible printed circuit board 1 is connected to a first fastening part 2. Similarly, the second fastening part 3 may also be directly formed in one process, so that the other end of the flexible printed circuit board 1 is connected to a second fastening part 3. Therefore, structural strength of the first fastening part 2 and the second fastening part 3 can be improved, and the flexible printed circuit board 1 can be fastened to the first fastening part 2 and the second fastening part 3, thereby improving reliability of relative connections between the flexible printed circuit board 1 and the first housing 100 and between the flexible printed circuit board 1 and the second housing 200 through the first fastening part 2 and the second fastening part 3. In addition, a quantity of components and parts can also be reduced, to reduce a quantity of assembly tolerances of the components and parts, thereby ensuring precision of assembling the first fastening part 2 and the second fastening part 3. In addition, because the first fastening part 2 or the second fastening part 3 is an integrated structure, a corresponding protruding part 5 may be directly formed at a corresponding position in a molding process of the first fastening part 2 or the second fastening part 3.

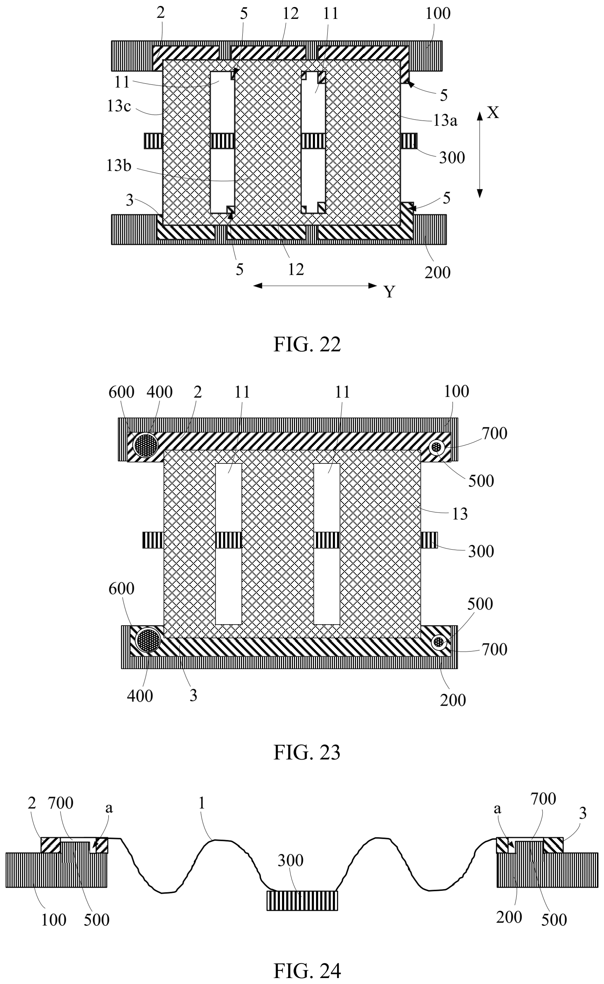

In a specific implementation, FIG. 22 is a yet further state diagram of a flexible printed circuit board 1 during application according to an embodiment of this application. As shown in FIG. 22, the flexible printed circuit board 1 is separated by the strip-shaped hole 11 into a plurality of transmission segments 13, a plurality of first fastening parts 2 or second fastening parts 3 are disposed, and each first fastening part 2 or second fastening part 3 is connected to a corresponding transmission segment 13. In this embodiment, each first fastening part 2 and each second fastening part 3 may be separately processed and manufactured, so that the first fastening part 2 and the second fastening part 3 with different specifications and sizes can be easily manufactured. Each first fastening part 2 and each second fastening part 3 can ensure relative strength of fastening between the flexible printed circuit board 1 and the first housing 100, and between the flexible printed circuit board 1 and the second housing 200, and can also reinforce each transmission segment 13 to ensure stability of each transmission segment 13. Refer to FIG. 22. For example, a first fastening part 2 with a small length in the first direction X may be separately manufactured, so that the first fastening part 2 does not protrude from an edge of the first housing 100. The first fastening part 2 may be connected to the transmission segment 13c, so that the transmission segment 13c with a small width has a large length. For example, a first fastening part 2 with a large length in the first direction X may be separately manufactured, so that at least a portion of the first fastening part 2 can protrude from an edge of the first housing 100, to form a protruding part 5. The first fastening part 2 may be connected to the transmission segment 13a or the transmission segment 13b, so that the transmission segment 13a with a large width or the transmission segment 13b with a large width has a small length.

In a specific implementation, FIG. 23 is a still yet further state diagram of a flexible printed circuit board 1 during application according to an embodiment of this application. As shown in FIG. 23, a first positioning post 400 and a second positioning post 500 are disposed on each of the first housing 100 and the second housing 200, both the first fastening part 2 and the second fastening part 3 are mechanical parts separately processed and manufactured, and the first fastening part 2 and the second fastening part 3 both are provided with a first positioning hole 600 and a second positioning hole 700. The first positioning hole 600 in the first fastening part 2 or the second fastening part 3 respectively fits with a corresponding first positioning post 400. The second positioning hole 700 in the first fastening part 2 or the second fastening part 3 respectively fits with a corresponding second positioning post 500. A gap between the second positioning post 500 and the second positioning hole 700 is greater than a gap between the first positioning post 400 and the first positioning hole 600.

The fitting gap between the first positioning post 400 and the first positioning hole 600 is small, so that the first fastening part 2 and the second fastening part 3 can be precisely located. The fitting gap between the second positioning post 500 and the second positioning hole 700 is large, so that the first fastening part 2 and the second fastening part 3 can be coarsely located, and the large fitting gap can provide space for adjusting the first fastening part 2 and the second fastening part 3. When the electronic device is folded, the first fastening part 2 and the second fastening part 3 can be automatically adjusted to proper positions through the gap between the second positioning post 500 and the second positioning hole 700. In this way, at least a portion of an amount of twist of the flexible printed circuit board 1 caused when the flexible printed circuit board 1 is bent may be transferred to an amount of movement of the first fastening part 2 and the second fastening part 3 at the gap between the second positioning post 500 and the second positioning hole 700, to reduce the amount of twist of the flexible printed circuit board 1, thereby prolonging the service life of the flexible printed circuit board 1.

For example, FIG. 24 is a diagram of an electronic device in a flattened state before being folded according to an embodiment of this application. As shown in FIG. 24, during determining of proper positions of the first fastening part 2 and the second fastening part 3 relative to the first housing 100 and the second housing 200, the first fastening part 2 and the second fastening part 3 may be first placed on the corresponding first housing 100 and the corresponding second housing 200 respectively, the first positioning hole 600 may be sleeved on the corresponding first positioning post 400, the second positioning hole 700 may be sleeved on the corresponding second positioning post 500, and the first fastening part 2 and the second fastening part 3 are not fastened onto the corresponding first housing 100 and the corresponding second housing 200. In this case, a gap a exists between the first positioning post 400 and the first positioning hole 600 in the first fastening part 2, and a gap a also exists between the first positioning post 400 and the first positioning hole 600 in the second fastening part 3. The two gaps a exist respectively on sides that are of the two first positioning posts 400 and that are close to each other.

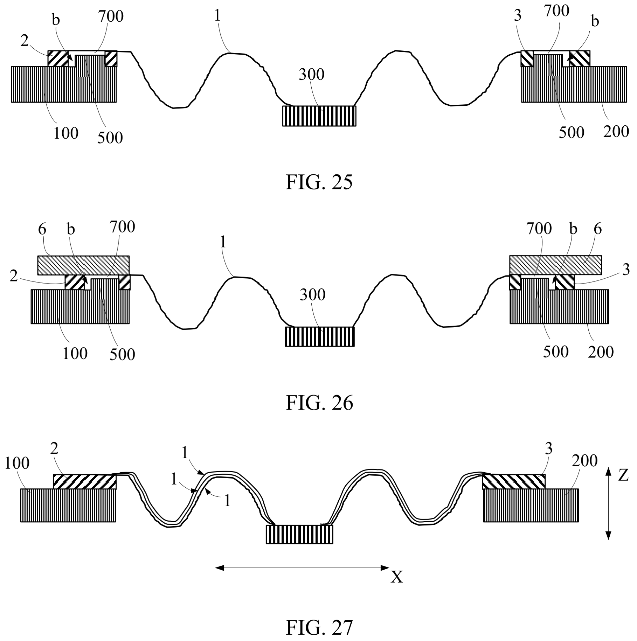

Then, the electronic device may be folded repeatedly. During folding, the first fastening part 2 and the second fastening part 3 are automatically adjusted to proper positions through the gap between the second positioning hole 700 and the second positioning post 500. After repeated folding at a specific frequency, the first fastening part 2 and the second fastening part 3 tend to be each at a stable position relative to the corresponding first housing 100 and the corresponding second housing 200, and the stable position is the proper position to be determined. FIG. 25 is a diagram of an electronic device in a flattened state after being repeatedly folded according to an embodiment of this application. As shown in FIG. 25, there is a gap b between the second positioning post 500 on the first fastening part 2 and the second positioning hole 700, and there is also a gap b between the second positioning post 500 on the second fastening part 3 and the second positioning hole 700. The two gaps b exist respectively on sides that are of the two second positioning posts 500 and that are away from each other, and there is no gap between sides that are of the two second positioning posts 500 and that are close to each other. In other words, after the electronic device is repeatedly folded, the first fastening part 2 and the second fastening part 3 are adjusted toward the sides that are close to each other, and tend to be stable. At this position, the flexible printed circuit board 1 has a small amount of distortion due to twist in a bending process.

In a specific implementation, FIG. 26 is even yet another state diagram of a flexible printed circuit board 1 during application according to an embodiment of this application. As shown in FIG. 26, the electronic device further includes a locking structure 6. The locking structure 6 tightly presses a side that is of the first fastening part 2 or the second fastening part 3 and that is away from the first housing 100 or the second housing 200, and the locking structure 6 is connected to the first housing 100 or the second housing 200. After the electronic device is folded repeatedly and the first fastening part 2 is adjusted to a proper position through the gap between the second positioning post 500 and the second positioning hole 700, the locking structures 6 may be employed to tightly press sides that are of the first fastening part 2 and the second fastening part 3 and that are away from the first housing 100 and the second housing 200, and then the locking structures 6 may be fastened to the corresponding first housing 100 and the second housing 200 through connecting pieces such as screws, pins, or rivets. In this way, the first fastening part 2 may be fastened to the first housing 100 and the second fastening part 3 may be fastened to the second housing 200 under the effect of traction forces of the connecting pieces.

In a specific implementation, FIG. 27 is a still even yet another state diagram of a flexible printed circuit board 1 during application according to an embodiment of this application. As shown in FIG. 27, a plurality of layers of flexible printed circuit boards 1 are disposed in a thickness direction Z of the electronic device. FIG. 27 shows an example in which three layers of flexible printed circuit boards 1 are disposed. When a large quantity of signals need to be transmitted on the flexible printed circuit board 1, the flexible printed circuit board 1 needs to have a large area. Because the length of the flexible printed circuit board 1 in the first direction X is relatively fixed, a requirement for the quantity of signals can be satisfied only by increasing the width of the flexible printed circuit board 1 in the second direction Y. However, increasing the size of the flexible printed circuit board 1 in the width direction causes a large amount of twist when the flexible printed circuit board 1 is bent.

Therefore, in this embodiment, a plurality of layers of flexible printed circuit boards 1 are stacked in a thickness direction Z of the electronic device, so that the signal quantity requirement can be satisfied through the plurality of flexible printed circuit boards 1 while a width of each flexible printed circuit board 1 in the second direction Y can be reduced, thereby avoiding twist of the flexible printed circuit board 1 when the flexible printed circuit board 1 is bent.

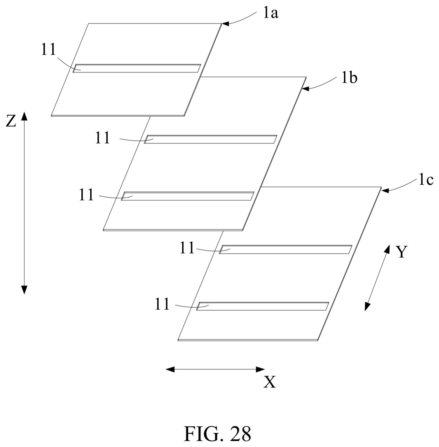

Each layer of flexible printed circuit board may have a same structure and a same size, or these flexible printed circuit boards may have different structures and different sizes. For example, as shown in FIG. 10 and FIG. 27, the structure shown in FIG. 10 may be used for each of the three layers of flexible printed circuit boards. To be specific, each layer of flexible printed circuit board is provided with two strip-shaped holes 11, and is separated by the two strip-shaped holes 11 into three transmission segments. For example, FIG. 28 is an exploded view of a plurality of layers of flexible printed circuit boards in a thickness direction Z of an electronic device. As shown in FIG. 28, three layers of flexible printed circuit boards are successively a flexible printed circuit board 1a, a flexible printed circuit board 1b, and a flexible printed circuit board 1c from top to bottom. The flexible printed circuit board 1a is provided with one strip-shaped hole 11, and the flexible printed circuit board 1b and the flexible printed circuit board 1c both are provided with two strip-shaped holes 11. A width of the flexible printed circuit board 1a in the second direction Y is less than widths of the flexible printed circuit board lb and the flexible printed circuit board 1c in the second direction Y. If the width of the flexible printed circuit board 1a in the second direction Y is small enough, for example, less than 15 mm, the flexible printed circuit board 1a may not need to provide the strip-shaped hole 11.

In addition, in some other embodiments, only two layers of flexible printed circuit boards may be disposed, or more than three layers of flexible printed circuit boards may be disposed. This is not limited in this embodiment.

The foregoing descriptions are merely preferred embodiments of this application and are not intended to limit this application. For a person skilled in the art, various modifications and changes may be made to this application. Any modification, equivalent replacement, improvement, or the like made without departing from the spirit and principle of this application shall fall within the protection scope of this application.

## Claims

1. An electronic device, comprising:
a first fastening part;
a rotating part;
a second fastening part, wherein the second fastening part and the first fastening part are respectively located on two sides of the rotating part in a first direction; and
at least one layer of flexible printed circuit board, wherein two ends of the flexible printed circuit board in the first direction are respectively connected to the first fastening part and the second fastening part, at least some portions that are on the flexible printed circuit board and that are located between the first fastening part and the second fastening part are connected to the rotating part, the flexible printed circuit board is provided with at least one strip-shaped hole, the strip-shaped hole extends in the first direction, and at least a portion of the strip-shaped hole is located between the first fastening part and the second fastening part.

2. The electronic device according to claim 1, wherein a length of the strip-shaped hole in the first direction is greater than or equal to a distance between the first fastening part and the second fastening part.

3. The electronic device according to claim 1 or 2, wherein one end of the strip-shaped hole in the first direction is aligned with an inner edge of the first fastening part; and/or
the other end of the strip-shaped hole in the first direction is aligned with an inner edge of the second fastening part.

4. The electronic device according to claim 1, wherein the flexible printed circuit board is separated by the strip-shaped hole into a plurality of transmission segments, the plurality of transmission segments are portions that are on the flexible printed circuit board and that are located between the first fastening part and the second fastening part, and at least some of the plurality of transmission segments have different widths in a second direction; and
the second direction is perpendicular to the first direction.

5. The electronic device according to claim 4, wherein a plurality of strip-shaped holes are spaced apart in the second direction.

6. The electronic device according to any one of claims 1 to 5, wherein a width of the strip-shaped hole in the second direction is greater than or equal to 1 mm, and the second direction is perpendicular to the first direction.

7. The electronic device according to claim 4, wherein at least one of the first fastening part and the second fastening part is provided with a protruding part, the protruding part protrudes between the first fastening part and the second fastening part, and the transmission segment is connected to the protruding part.

8. The electronic device according to claim 7, wherein there are a plurality of protruding parts on the first fastening part and/or the second fastening part, and at least some of the protruding parts have different protruding lengths in the first direction.

9. The electronic device according to any one of claims 6 to 8, wherein the rotating part comprises a plurality of connection parts, each connecting part is connected to a corresponding transmission segment, distances between at least some of the connection parts and the first fastening part are different, and/or distances between at least some of the connection parts and the second fastening part are different.

10. The electronic device according to claim 1, wherein the electronic device comprises a first housing, a second housing, and a hinge assembly, the first housing and the second housing are respectively located on two sides of the hinge assembly, and the first housing and the second housing are separately in rotary connection to the hinge assembly; and
a portion of the first housing forms the first fastening part, a portion of the second housing forms the second fastening part, and the hinge assembly is the rotating part.

11. The electronic device according to claim 1, wherein the electronic device comprises a first housing, a second housing, and a hinge assembly, the first housing and the second housing are respectively located on two sides of the hinge assembly, and the first housing and the second housing are separately in rotary connection to the hinge assembly; and
one side of the first fastening part is connected to the flexible printed circuit board, one side that is of the first fastening part and that is away from the flexible printed circuit board is connected to the first housing, one side of the second fastening part is connected to the flexible printed circuit board, and one side that is of the second fastening part and that is away from the flexible printed circuit board is connected to the second housing.

12. The electronic device according to claim 11, wherein the first fastening part or the second fastening part is an integrated structure.

13. The electronic device according to claim 11, wherein the flexible printed circuit board is separated by the strip-shaped hole into a plurality of transmission segments, a plurality of first fastening parts or second fastening parts are disposed, and each first fastening part or second fastening part is connected to a corresponding transmission segment.

14. The electronic device according to claim 11, wherein a first positioning post and a second positioning post are disposed on each of the first housing and the second housing, the first fastening part and the second fastening part both are provided with a first positioning hole and a second positioning hole, the first positioning hole in the first fastening part or the second fastening part respectively fits with a corresponding first positioning post, and the second positioning hole in the first fastening part or the second fastening part respectively fits with a corresponding second positioning post; and
a gap between the second positioning post and the second positioning hole is greater than a gap between the first positioning post and the first positioning hole.

15. The electronic device according to claim 14, wherein the electronic device further comprises a locking structure, the locking structure tightly presses a side that is of the first fastening part or the second fastening part and that is away from the first housing or the second housing, and the locking structure is connected to the first housing or the second housing.

16. The electronic device according to any one of claims 1 to 15, wherein a plurality of layers of flexible printed circuit boards are disposed in a thickness direction of the electronic device.

17. The electronic device according to any one of claims 1 to 15, wherein the flexible printed circuit board is an integrated structure.

18. A circuit connection assembly, comprising a flexible printed circuit board, a first fastening part, and a second fastening part, wherein one end of the flexible printed circuit board in a first direction is connected to at least one first fastening part, and the other end of the flexible printed circuit board in the first direction is connected to at least one second fastening part; and
the flexible printed circuit board is provided with at least one strip-shaped hole, the strip-shaped hole extends in the first direction, and at least a portion of the strip-shaped hole is located between the first fastening part and the second fastening part.
